# EUROPÄISCHE PATENTANMELDUNG

(11) **EP 2 743 942 A2**
(43) Veröffentlichungstag der Anmeldung: **18.06.2014**
(21) Anmeldenummer: 13188807.5
(22) Anmeldetag: 16.10.2013
(51) Int. Cl.: H01F 27/06

(54) **Leistungsbauelementeinrichtung**

(30) Priorität: 12.12.2012 DE 102012222959
(71) Anmelder: SEMIKRON Elektronik GmbH & Co. KG, 90431 Nürnberg (DE)
(72) Erfinder: Frank, Thomas, 91207 Lauf (DE); Kalkmann, Bernhard, 91126 Schwabach (DE); Müller-Schmidt, Liane, 90518 Altdorf (DE); Teuber, Sven, 90610 Winkelhaid (DE)

(57) **Zusammenfassung**

Die Erfindung betrifft ein Leistungsbauelementeinrichtung mit einem Kühlkörper (2), der eine Ausnahme (3) aufweist, wobei die Ausnahme (3) eine Bodenfläche (4) und eine erste Seitenfläche (5) aufweist, wobei die erste Seitenfläche (5) der Ausnahme (3) einen Wickel (α) zur Bodenfläche (4) von kleiner als 90° aufweist, wobei die Leistungsbauelementeinrichtung (1,1',1'') ein erstes passives elektrisches Bauelement (20) mit einem Auflageelement (6) aufweist, wobei die der ersten Seitenfläche (5) der Ausnahme (3) zugewandte erste Seitenfläche (7) des Auflageelements (6) den gleichen Wickel zur Bodenfläche (4) aufweist wie die erste Seitenfläche (5) der Ausnahme (3) zur Bodenfläche (4), wobei ein Druckübertragungselement (19) eine der ersten Seitenfläche (7)des Auflageelements (19) abgewandte erste Druckübertragungselementseitenfläche (14) aufweist, wobei die Bodenfläche (4) einen Wickel (γ) zur ersten Druckübertragungselementseitenfläche (14) von kleiner als 90° aufweist, wobei eine Druckerzeugungsvorrichtung (10) eine Kraft (F) auf die erste Druckübertragungselementseitenfläche (14) ausübt, so dass über das Druckübertragungselement (19) das Auflageelement (6) gegen die erste Seitenfläche (5) der Ausnahme (3) gedrückt wird. Die Erfindung schafft eine an unterschiedliche passive elektrische Bauelemente anpassbare Leistungsbauelementeinrichtung, bei der eine gute Kühlung des jeweiligen passiven elektrischen Bauelements gewährleistet ist.

## Beschreibung

Die Erfindung betrifft eine Leistungsbauelementeinrichtung.

Zur Kühlung von passiven elektrischen Bauelementen, wie z.B. Drosseln, Transformatoren, elektrischen Widerständen und Kondensatoren, werden techniküblich die passiven elektrischen Bauelemente an einem Kühlkörper, mittels Schrauben, Klammern oder einem Verguss befestigt.

Um eine gute Wärmeabfuhr, der im Betrieb von den passiven elektrischen Bauelementen erzeugten Wärme an den Kühlkörper zu gewährleisten ist es dabei wünschenswert, dass das betreffende passive elektrische Bauelement an möglichst vielen seiner Seitenflächen einen Kontakt mit dem Kühlkörper aufweist. Bei techniküblichen Leistungsbauelementeinrichtungen, welche ein passives elektrisches Bauelement und eine Kühlkörper aufweisen, ist es deshalb häufig notwendig die Form des Kühlkörpers an die Form des passiven elektrischen Bauelements anzupassen, so dass möglichst viel Wärme von dem passiven elektrischen Bauelement auf den Kühlkörper übertragen werden kann. Dies macht die Herstellung von techniküblichen Leistungsbauelementeinrichtungen technisch aufwändig, da für unterschiedliche passive elektrische Bauelemente unterschiedliche Kühlkörper hergestellt werden müssen, wenn eine gute Kühlung des jeweiligen passiven elektrischen Bauelements gewährleistet werden soll. Diese Problematik verschärft sich noch, wenn die Leistungsbauelementeinrichtung mehrere, gegebenenfalls unterschiedliche, passive elektrische Bauelemente aufweist, die mittels eines einzelnen Kühlköpers der Leistungsbauelementeinrichtung gekühlt werden sollen.

Es ist Aufgabe der Erfindung eine an unterschiedliche passive elektrische Bauelemente anpassbare Leistungsbauelementeinrichtung zu schaffen, bei der eine gute Kühlung des jeweiligen passiven elektrischen Bauelements gewährleistet ist.

Diese Aufgabe wird gelöst durch eine Leistungsbauelementeinrichtung mit einem Kühlkörper, der eine Ausnahme aufweist, wobei die Ausnahme eine Bodenfläche und eine erste Seitenfläche aufweist, wobei die erste Seitenfläche der Ausnahme einen Wickel zur Bodenfläche von kleiner als 90° aufweist wobei die Leistungsbauelementeinrichtung ein erstes passives elektrisches Bauelement mit einem Auflageelement aufweist, wobei das Auflageelement auf der Bodenfläche angeordnet ist und die der ersten Seitenfläche der Ausnahme zugewandte erste Seitenfläche des Auflageelements den gleichen Wickel zur Bodenfläche aufweist wie die erste Seitenfläche der Ausnahme zur Bodenfläche, wobei die Leistungsbauelementeinrichtung ein auf der Bodenfläche angeordnetes Druckübertragungselement aufweist, wobei das Druckübertragungselement eine der ersten Seitenfläche des Auflageelements abgewandte erste Druckübertragungselementseitenfläche aufweist, wobei die Bodenfläche einen Wickel zur ersten Druckübertragungselementseitenfläche von kleiner als 90° aufweist, wobei die Leistungsbauelementeinrichtung eine Druckerzeugungsvorrichtung aufweist, die eine Kraft auf die erste Druckübertragungselementseitenfläche ausübt, so dass über das Druckübertragungselement das Auflageelement gegen die erste Seitenfläche der Ausnahme gedrückt wird.

Vorteilhafte Ausbildungen der Erfindung ergeben sich aus den abhängigen Ansprüchen.

Es erweist sich als vorteilhaft, wenn das Druckübertragungselement gegenüberliegend zu einer der ersten Seitenfläche des Auflageelements abgewandten zweiten Seitenfläche des Auflageelements angeordnet ist, da dann auf besonders einfache Art und Weise die Kraft vom Druckübertragungselement auf das Auflageelement in Richtung der ersten Seitenfläche der Ausnahme übertragen werden kann.

Ferner erweist es sich als vorteilhaft, wenn die Bodenfläche einen Wickel zur zweiten Seitenfläche des Auflageelements von kleiner als 90° aufweist und die Bodenfläche zu einer der zweiten Seitenfläche des Auflageelements zugewandten zweiten Druckübertragungselementseitenfläche des Druckübertragungselements den gleichen Winkel aufweist wie die Bodenfläche zur zweiten Seitenfläche des Auflageelements, da dann das Auflageelement im Bereich der zweiten Seitenfläche des Auflageelements gegen die Bodenfläche der Ausnahme gedrückt wird und somit eine besonders gute thermische Anbindung des Auflageelements an die Bodenfläche der Ausnahme erzielt wird.

Weiterhin erweist es sich als vorteilhaft, wenn das Druckübertragungselement einstückig mit dem Auflageelement ausgebildet ist. Hierdurch wird die Realisierung einer besonders einfach aufgebauten Leistungsbauelementeinrichtung ermöglicht.

Ferner erweist es sich als vorteilhaft, wenn die Ausnahme eine der ersten Seitenfläche der Ausnahme zugewandte zweite Seitenfläche, welche die Seitenfläche einer ersten Seitenwand des Kühlkörpers bildet, aufweist, wobei die erste Seitenwand des Kühlkörpers die Gegenkraft zur Kraft, die die Druckerzeugungsvorrichtung auf die erste Druckübertragungselementseitenfläche ausübt, aufnimmt. Hierdurch wird die Realisierung einer besonders einfach aufgebauten Leistungsbauelementeinrichtung ermöglicht.

Ferner erweist es sich als vorteilhaft, wenn das erste passive elektrische Bauelement als Transformator mit einem magnetisch leitfähigen Kern oder als Drossel mit einem magnetisch leitfähigen Kern ausgebildet ist und das Auflageelement in Form des magnetisch leitfähigen Kerns des Transformators oder der Drossel ausgebildet ist, oder das erste passive elektrische Bauelement als elektrischer Widerstand und das Auflageelement in Form des Gehäuses des elektrischen Widerstands ausgebildet ist, oder das erste passive elektrische Bauelement als Kondensator ausgebildet ist und das Auflageelement in Form des Gehäuses des Kondensators ausgebildet ist. Transformatoren, Drosseln, elektrische Widerstände und Kondensatoren stellen übliche Ausbildungen von passiven elektrischen Bauelementen dar.

Weiterhin erweist es sich als vorteilhaft, wenn zwischen dem Auflageelement und der Bodenfläche eine erste wärmeleitende Schicht angeordnet ist und zwischen dem Auflageelement und erster Seitenfläche der Ausnahme eine zweite wärmeleitende Schicht angeordnet ist. Hierdurch kann eine besonders gute thermische Anbindung des Auflageelements an die Bodenfläche und an der ersten Seitenfläche der Ausnahme erzielt werden.

Weiterhin erweist es sich als vorteilhaft, wenn die Dicken der ersten und zweiten Schicht unterschiedlich sind und/oder das Material aus dem die erste und die zweite wärmeleitende Schicht bestehen unterschiedlich ist, da dann der jeweilige thermische Übergangswiderstand zwischen dem Auflageelement und der Bodenfläche, und zwischen dem Auflageelement und der ersten Seitenfläche der Ausnahme gezielt eingestellt werden kann.

Ferner erweist es sich als vorteilhaft, wenn die Leistungsbauelementeinrichtung ein zweites passives elektrisches Bauelement mit einem Auflageelement aufweist, wobei das Auflageelement des zweiten passiven elektrischen Bauelements in gleicher Form wie das Auflageelement des ersten passiven elektrisches Bauelements in der Ausnahme des Kühlkörpers angeordnet und mit dem Kühlkörper verbunden ist, da somit, mittels eines einzelnen Kühlkörpers, gleiche oder unterschiedliche passive elektrische Bauelemente gekühlt werden können.

Weiterhin erweist es sich als vorteilhaft, wenn das zweite passive elektrische Bauelement als Transformator mit einem magnetisch leitfähigen Kern oder als Drossel mit einem magnetisch leitfähigen Kern ausgebildet ist und das Auflageelement des zweiten passiven elektrischen Bauelements in Form des magnetisch leitfähigen Kerns des Transformators oder der Drossel ausgebildet ist, oder das zweite passive elektrische Bauelement als elektrischer Widerstand und das Auflageelement des zweiten passiven elektrischen Bauelements in Form des Gehäuses des elektrischen Widerstands ausgebildet ist, oder das zweite passive elektrische Bauelement als Kondensator ausgebildet ist und das Auflageelement des zweiten passiven elektrischen Bauelements in Form des Gehäuses des Kondensators ausgebildet ist. Transformatoren, Drosseln, elektrische Widerstände und Kondensatoren stellen übliche Ausbildungen von passiven elektrischen Bauelementen dar.

Ausführungsbeispiele der Erfindung sind in den Figuren dargestellt und werden im Folgenden näher erläutert. Dabei zeigen:
- FIG 1: eine schematisierte perspektivische Darstellung einer erfindungsgemäßen Leistungsbauelementeinrichtung,
- FIG 2: eine schematisierte Schnittdarstellung einer erfindungsgemäßen Leistungsbauelementeinrichtung,
- FIG 3: eine schematisierte Schnittdarstellung einer weiteren Ausbildung der erfindungsgemäßen Leistungsbauelementeinrichtung und
- FIG 4: eine schematisierte Schnittdarstellung einer weiteren Ausbildung der erfindungsgemäßen Leistungsbauelementeinrichtung.

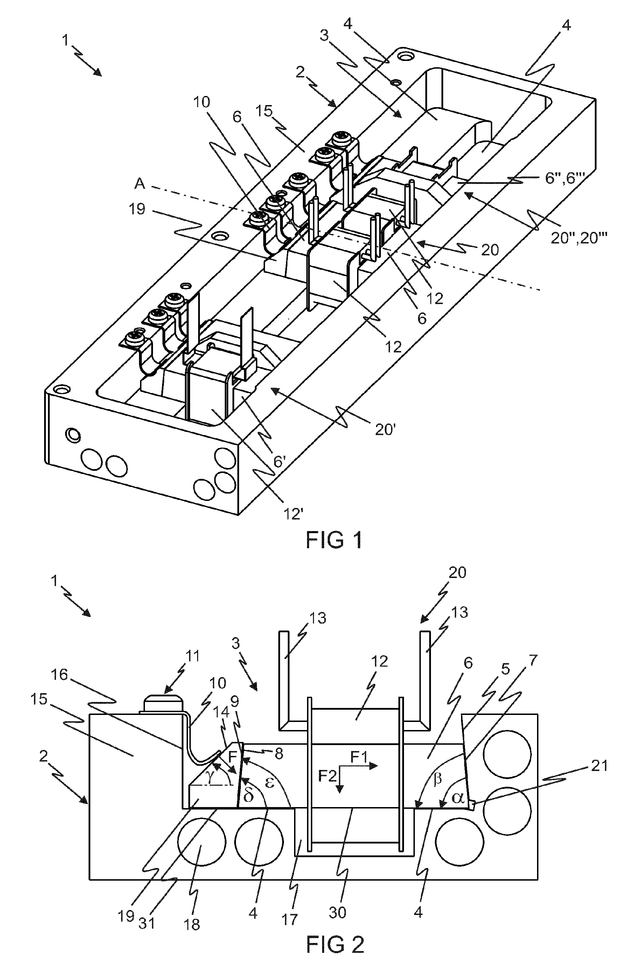

In FIG 1 ist eine schematisierte perspektivische Darstellung einer erfindungsgemäßen Leistungsbauelementeinrichtung 1 dargestellt. In FIG 2 ist eine zu FIG 1 zugehörige schematisierte Schnittdarstellung eines in FIG 1 entlang der Linie A verlaufenden Schnitts der erfindungsgemäßen Leistungsbauelementeinrichtung 1 dargestellt.

Es sei an dieser Stelle angemerkt, dass im Folgenden, wie in den Figuren dargestellt, alle Wickel in Richtung gegen den Uhrzeigersinn angegeben sind. Weiterhin sei angemerkt, dass im Sinne der Erfindung bei einem Wickel zwischen zwei Flächen, die sich physikalisch nicht schneiden, der betreffende jeweilige Wickel zwischen den sich schneidenden gedachten virtuellen Verlängerungen der betreffenden beiden Flächen verstanden wird.

Die erfindungsgemäße Leistungsbauelementeinrichtung 1 weist einen Kühlkörper 2, der eine Ausnahme 3 aufweist, auf. Die Ausnahme 3 weist eine Bodenfläche 4 und eine erste Seitenfläche 5 auf, wobei die erste Seitenfläche 5 der Ausnahme 4 einen Wickel α zur Bodenfläche 4 von kleiner als 90° aufweist. Vorzugsweise weist die erste Seitenfläche 5 der Ausnahme 4 einen Wickel α zur Bodenfläche 4 von kleiner als 88° und insbesondere kleiner als 85° auf.

Weiterhin weist die Leistungsbauelementeinrichtung 1 ein erstes passives elektrisches Bauelement 20 mit einem Auflageelement 6 auf, wobei das Auflageelement 6 auf der Bodenfläche 4 angeordnet ist. Im Rahmen des Ausführungsbeispiels ist das erste passive elektrische Bauelement 6 als Transformator ausgebildet und das Auflageelement 6 in Form des magnetisch leitfähigen Kerns des Transformators ausgebildet, der z.B. in Form eines Eisenlegierungsbleche aufweisenden Kerns oder als Ferritkern ausgebildet sein kann. Der Transformator weist um den Kern verlaufende Spulen 12 auf. Die Spulen 12 sind mit elektrischen Anschlüssen 13 verbunden. Alternativ kann das erste passive elektrische Bauelement 6 z.B. auch als Drossel ausgebildet sein und das Auflageelement 6 in Form des magnetisch leitfähigen Kerns der Drossel ausgebildet sein, die z.B. in Form eines Eisenlegierungsbleche aufweisenden Kerns oder als Ferritkern ausgebildet sein kann.

Alternativ kann das erste passive elektrische Bauelement 6 auch als elektrischer Widerstand und das Auflageelement 6 in Form des Gehäuses des elektrischen Widerstands ausgebildet sein oder das erste passive elektrische Bauelement 6 als Kondensator ausgebildet sein und das Auflageelement 6 in Form des Gehäuses des Kondensators ausgebildet sein.

Die der ersten Seitenfläche 5 der Ausnahme 3 zugewandte erste Seitenfläche 7 des Auflageelements 6 weist den gleichen Wickel zur Bodenfläche 4 auf wie die erste Seitenfläche 5 der Ausnahme 3 zur Bodenfläche 4, d.h. der Wickel β der ersten Seitenfläche 7 des Auflageelements 6 zur Bodenfläche 4 entspricht dem Wickel α der ersten Seitenfläche 5 der Ausnahme 3 zur Bodenfläche 4. Die erste Seitenfläche 7 des Auflageelements 6 ist korrespondierend zur ersten Seitenfläche 5 der Ausnahme 3 angeordnet. Beim Ausführungsbeispiel ist die erste Seitenfläche 7 des Auflageelements 6 der ersten Seitenfläche 5 der Ausnahme 3 gegenüberliegend angeordnet. Die der Bodenfläche 4 zugewandte Grundfläche 30 des Auflageelements 6 verläuft parallel zur Bodenfläche 4 der Ausnahme 3.

Die Leistungsbauelementeinrichtung 1 weist ein auf der Bodenfläche 4 angeordnetes Druckübertragungselement 19 auf, wobei das Druckübertragungselement 19 eine der ersten Seitenfläche 7 des Auflageelements 6 abgewandte erste Druckübertragungselementseitenfläche 14 aufweist. Die Bodenfläche 4 weist einen Wickel γ zur ersten Druckübertragungselementseitenfläche 14 von kleiner als 90° und insbesondere von kleiner als 88° auf. Vorzugsweiseweist die Bodenfläche 4 einen Wickel γ zur ersten Druckübertragungselementseitenfläche 14 von 20° bis 70° auf. Die der Bodenfläche 4 zugewandte Grundfläche 31 des Druckübertragungselements 19 verläuft parallel zur Bodenfläche 4 der Ausnahme 3. Das Druckübertragungselement 19 ist vorzugsweise gegenüberliegend zu einer der ersten Seitenfläche 7 des Auflageelements 6 abgewandten zweiten Seitenfläche 8 des Auflageelements 6 angeordnet. Die der zweiten Seitenfläche 8 des Auflageelements 6 zugewandte zweite Druckübertragungselementseitenfläche 9 des Druckübertragungselements 19 ist vorzugsweise korrespondierend zu der zweiten Seitenfläche 8 des Auflageelements 6 angeordnet. Weiterhin ist die zweite Druckübertragungselementseitenfläche 9 des Druckübertragungselements 19 vorzugsweise gegenüberliegend zu der zweiten Seitenfläche 8 des Auflageelements 6 angeordnet.

Weiterhin weist die Leistungsbauelementeinrichtung 1 eine Druckerzeugungsvorrichtung 10 auf, die eine Kraft F auf die erste Druckübertragungselementseitenfläche 14 ausübt, so dass über das Druckübertragungselement 19 das Auflageelement 6 gegen die erste Seitenfläche 5 der Ausnahme 3 gedrückt wird. Die Druckerzeugungseinrichtung ist vorzugsweise in Form eines Federelements, das z.B. in Form einer Klammer 10 vorliegen kann, ausgebildet. Die von der Kraft F abgespaltete Kraft F1, welche in parallel zur Bodenfläche 4 in Richtung auf die erste Seitenfläche 5 der Ausnahme 3 wirkt, drückt das Auflageelement 6 gegen die erste Seitenfläche 5 der Ausnahme 3. Da die erste Seitenfläche 5 der Ausnahme 3 einen Wickel α zur Bodenfläche 4 von kleiner als 90° aufweist, wird das Auflageelement 6 im Bereich der ersten Seitenfläche 7 des Auflageelements 6 gegen die Bodenfläche 4 der Ausnahme 3 gedrückt und somit eine gute thermische Anbindung des Auflageelement 6 an die Bodenfläche 4 erzielt. Je kleiner der Winkel α ist desto größer wird die Kraft mit der das Auflageelement 6 im Bereich der ersten Seitenfläche 7 gegen die Bodenfläche 4 der Ausnahme 3 gedrückt wird. Da die erste Seitenfläche 5 der Ausnahme 3 einen Wickel α zur Bodenfläche 4 von kleiner als 90° aufweist wird weiterhin verhindert, dass das Auflageelement 6 sich von der Bodenfläche 4 weg bewegen kann. Es entsteht solchermaßen eine formschlüssige Verbindung zwischen dem Auflageelement 6 und der ersten Seitenfläche 5 der Ausnahme 3 und somit eine formschlüssige Verbindung zwischen dem Auflageelement 6 und dem Kühlkörper 2. Es sei angemerkt, dass wie beim Ausführungsbeispiel, die Leistungsbauelementeinrichtung 1 auch mehrere Druckerzeugungsvorrichtungen 10 aufweisen kann, die zusammen eine Kraft F auf die erste Druckübertragungselementseitenfläche 14 ausüben und somit die Größe der Kraft F gezielt über die Anzahl der verwendeten Druckerzeugungsvorrichtungen 10 einstellbar ist.

Aus fertigungstechnischen Gründen weist der Kühlkörper 2 vorzugsweise an der Kante an der die Bodenfläche 4 und die erste Seitenfläche 7 des Auflageelements 6 zusammenstoßen eine Nut 21 auf. Die von dem ersten passiven elektrischen Bauelement 12 erzeugte Wärme wird über die erste Seitenfläche 7 des Auflageelements 6 und über die Bodenfläche 30 des Auflageelement 6 auf den Kühlkörper 2 übertragen. Weiterhin wird die vom ersten passiven elektrischen Bauelement 12 erzeugte Wärme über die zweite Seitenfläche 8 des Auflageelements 6 auf das Druckübertragungselement 19 und von diesem auf den Kühlkörper 2 übertragen, so dass das erste passive elektrische Bauelement 12 von drei Seiten gekühlt wird und somit sehr gut gekühlt wird. Vorzugsweise besteht das Druckübertragungselement 19 aus einem thermisch gut leitfähigen Material wie z.B. Kupfer oder Aluminium.

Im Rahmen des Ausführungsbeispiels weist die Bodenfläche 4 der Ausnahme 3 einen Wickel δ zur zweiten Seitenfläche 8 des Auflageelements 6 von kleiner als 90° auf. Vorzugsweise weist die Bodenfläche 4 der Ausnahme 3 einen Wickel δ zur zweiten Seitenfläche 8 des Auflageelements 6 von kleiner als 88° und insbesondere von kleiner als 85° auf. Die Bodenfläche 6 der Ausnahme 3 weistzu der der zweiten Seitenfläche 8 des Auflageelements 6 zugewandten zweiten Druckübertragungselementseitenfläche 9 des Druckübertragungselements 19 den gleichen Winkel auf wie die Bodenfläche 6 der Ausnahme 3 zur zweiten Seitenfläche 8 des Auflageelements 6, d.h. der Wickel ε Bodenfläche 4 der Ausnahme 2 zur zweiten Druckübertragungselementseitenfläche 9 des Druckübertragungselements 19 entspricht dem Wickel δ der Bodenfläche 4 der Ausnahme 3 zur zweiten Seitenfläche 8 des Auflageelements 6. Die zweite Druckübertragungselementseitenfläche 9 ist vorzugsweise korrespondierend zur zweiten Seitenfläche 8 des Auflageelements 6 angeordnet. Beim Ausführungsbeispiel ist die zweite Druckübertragungselementseitenfläche 9 der zweiten Seitenfläche 8 des Auflageelements 6 gegenüberliegend angeordnet.

Da die Bodenfläche 4 der Ausnahme 3 einen Wickel δ zur zweiten Seitenfläche 8 des Auflageelements 6 von kleiner als 90° aufweist, wird das Auflageelement 6 im Bereich der zweiten Seitenfläche 8 des Auflageelements 6 gegen die Bodenfläche 4 der Ausnahme 3 gedrückt.

Da die erste Seitenfläche 5 der Ausnahme 3 einen Wickel α zur Bodenfläche 4 von kleiner als 90° aufweist und die Bodenfläche 4 derAusnahme 3 einen Wickel δ zur zweiten Seitenfläche 8 des Auflageelements 6 von kleiner als 90° aufweist wird das Auflageelements 6 mit der Gesamtkraft F2 gegen die Bodenfläche 4 der Ausnahme 3 gedrückt und somit eine sehr gute thermische Anbindung des Auflageelement 6 an der Bodenfläche 4 erzielt.

Im Rahmen des Ausführungsbeispiels weist die Ausnahme 3 eine der ersten Seitenfläche 5 der Ausnahme 3 zugewandte zweite Seitenfläche 16, welche die Seitenfläche einer ersten Seitenwand 15 des Kühlkörpers 2 bildet, auf, wobei die erste Seitenwand 15 des Kühlkörpers 2 die Gegenkraft zur Kraft F, die die Druckerzeugungsvorrichtung 10 auf die erste Druckübertragungselementseitenfläche 14 ausübt, aufnimmt. Hierzu ist vorzugsweise die Druckerzeugungsvorrichtung 10 mittels einer Schraubverbindung 11 mit der ersten Seitenwand 15 des Kühlkörpers 2 verbunden. Es sei dabei angemerkt, dass in FIG 2 bis FIG 4 die Schraubverbindung 11 der Übersichtlichkeit halber nur stark schematisiert dargestellt ist, indem nur der Schraubenkopf der zugehörigen Schraube dargestellt ist. Alternativ hierzu kann die erste Seitenwand 15 des Kühlkörpers 2 oder die Bodenfläche 4 der Ausnahme 3 auch ein Gegenlager, z.B. in Form einer Kante, aufweisen gegen die das Federelement 10 drückt oder die Druckerzeugungsvorrichtung 10 kann z.B. mittels einer Schraubverbindung mit der Bodenfläche 4 der Ausnahme 3 verbunden sein.

Vorzugsweise weist der Kühlkörper 2 in der Ausnahme 3 eine Aussparung 17 auf, die einen Teil der Bodenfläche 4 ausspart. Vorzugweise ist ein Teil einer jeweiligen Spule 12 des Transformators 20 in der Aussparung 17 angeordnet. Es sei dabei angemerkt, dass in FIG 2 bis FIG 4 der Übersichtlichkeitshalber die Spule 12 stark schematisiert in Form einer Draufsicht dargestellt ist.

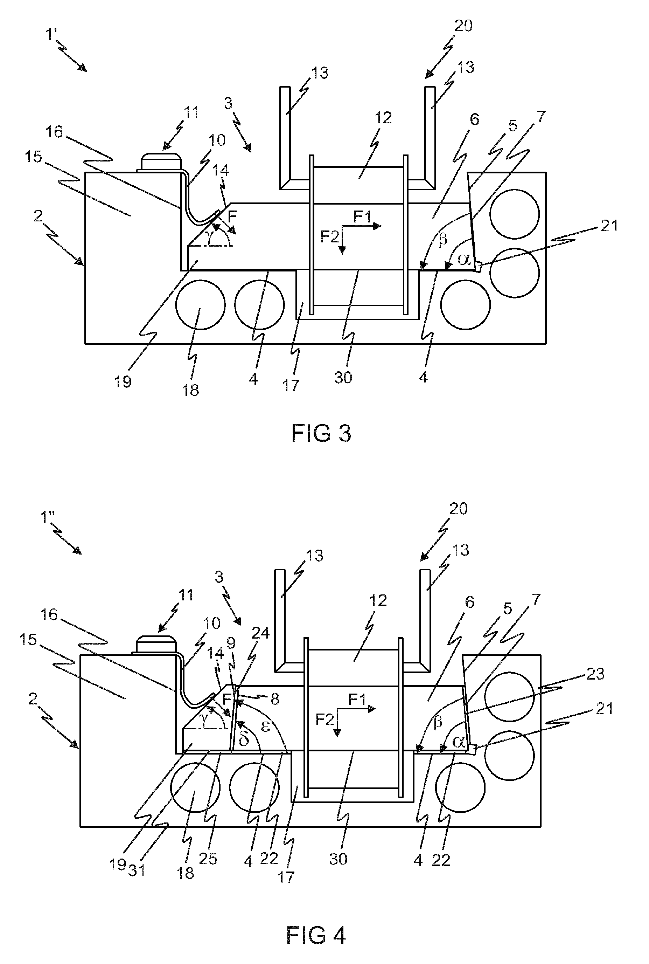

In FIG 3 ist eine schematisierte Schnittdarstellung einer weiteren Ausbildung einer erfindungsgemäßen Leistungsbauelementeinrichtung 1' dargestellt, die mit der zuvor beschriebenen erfindungsgemäßen Leistungsbauelementeinrichtung 1 bis auf das Merkmal, dass das Druckübertragungselement 19 einstückig mit dem Auflageelement 6 ausgebildet ist, übereinstimmt. Hierdurch wird die Realisierung einer besonders einfach aufgebauten Leistungsbauelementeinrichtung ermöglicht.

In FIG 4 ist eine schematisierte Schnittdarstellung einer weiteren Ausbildung einer erfindungsgemäßen Leistungsbauelementeinrichtung 1" dargestellt, die mit der zuvor beschriebenen erfindungsgemäßen Leistungsbauelementeinrichtung 1 übereinstimmt, wobei bei der Ausbildung der Erfindung gemäß FIG 4 zwischen dem Auflageelement 6 und der Bodenfläche 4 eine erste wärmeleitende Schicht 22 angeordnet ist und zwischen dem Auflageelement 6 und der ersten Seitenfläche 5 der Ausnahme 3 eine zweite wärmeleitende Schicht 23 angeordnet ist. Vorzugsweise kann auch zusätzlich zwischen dem Auflageelement 6 und der zweiten Druckübertragungselementseitenfläche 9 eine dritte wärmeleitende Schicht 24 und/oder zwischen dem Druckübertragungselement 19 und der Bodenfläche 4 eine vierte wärmeleitende Schicht 25 angeordnet sein. Die Dicken der ersten, zweiten, dritten und/oder der vierten Schicht 22, 23, 24, 25 können dabei unterschiedlich sein bzw. zum Teil unterschiedlich sein und/oder die Materialien aus denen die Schichten 22, 23, 24, 25 bestehen können unterschiedlich bzw. zum Teil unterschiedlich sein. Die Schichten 22, 23, 24, und/oder 25 bestehen vorzugweise aus einer Wärmeleitpaste, wobei falls die Schichten bzw. ein Teil der Schichten aus unterschiedlichen Materialen bestehen sollen, die Schichten bzw. ein Teil der Schichten aus unterschiedlichen Wärmeleitpasten bestehen können, die eine unterschiedliche Wärmeleitfähigkeit aufweisen. Selbstverständlich können die Schichten 22, 23, 24, und/oder 25 aber jeweilig auch als Feststoffkörper ausgebildet sein. Durch eine gezielte Wahl der Dicke der Schichten bzw. der Dicke der Schichten bei einem Teil der Schichten und/oder durch eine gezielte Wahl des Materials der Schichten bzw. des Materials bei einem Teil der Schichten kann der jeweilige thermische Übergangswiderstand gezielt eingestellt werden und somit z.B. erreicht werden, dass das passive elektrische Bauelement 20 gut gekühlt wird aber beim Betrieb des passiven elektrischen Bauelements 20, das passive elektrische Bauelement 20 nicht zu kühl wird, sondern beim Betrieb eine bestimmte gewünschte Betriebstemperatur annimmt, bei der es z.B. mit besonders hoher Güte und/oder besonders zuverlässig arbeitet.

Selbstverständlich können die erste und zweite wärmeleitende Schicht 22 und 23 auch in identischer Weise wie oben beschrieben beim Ausführungsbeispiel der Erfindung gemäß FIG 3 vorhanden sein und somit die Leistungsbauelementeinrichtung 1' ebenfalls eine entsprechend ausgebildete erste und zweite wärmeleitende Schicht 22 und 23 aufweisen.

Die erfindungsgemäße Leistungsbauelementeinrichtung 1, 1' und 1" kann neben dem ersten passiven elektrischen Bauelement noch weitere passive elektrische Bauelemente mit jeweiligen Auflageelementen aufweisen, die in gleicher Form wie das erste passive elektrische Bauelement in der Ausnahme des Kühlkörpers angeordnet und mit dem Kühlkörper verbunden sind. Die passiven elektrischen Bauelemente können sich dabei sowohl in ihrem Typ (Transformator, Drossel, elektrischer Widerstand, Kondensator) als auch in ihrer Größe und/oder Form unterscheiden. Somit ist es möglich mittels eines einzelnen Kühlkörpers gleiche oder unterschiedliche passive elektrische Bauelemente zu kühlen. Dabei kann das Druckübertragungselement des jeweiligen passiven elektrischen Bauelements einstückig mit dem Auflageelement 6 ausgebildet sein oder auch nicht einstückig mit dem Auflageelement 6 ausgebildet sein.

So kann, wie in FIG 1 dargestellt, die erfindungsgemäße Leistungsbauelementeinrichtung z.B. ein zweites passives elektrisches Bauelement 20' mit einem Auflageelement 6' aufweisen, wobei das Auflageelement 6' des zweiten passiven elektrischen Bauelements 20' in gleicher Form wie das Auflageelement 6 des ersten passiven elektrisches Bauelements 20 in der Ausnahme 3 des Kühlkörpers 2 angeordnet und mit dem Kühlkörper 2 verbunden ist, so dass die bezüglich dem ersten passiven elektrischen Bauelements 20 oben aufgeführte Beschreibung auch für das zweite passive elektrische Bauelement 20' zutrifft. Beim Ausführungsbeispiel liegt das zweite passive elektrische Bauelement 20' in Form einer Drossel und das Auflageelement 6' des zweiten passiven elektrischen Bauelements 20' in Form eines magnetisch leitfähigen Kerns vor. Um den magnetisch leitfähigen Kern verläuft eine Spule 12' der Drossel.

Weiterhin kann, wie in FIG 1 dargestellt, die erfindungsgemäße Leistungsbauelementeinrichtung z.B. ein drittes passives elektrisches Bauelement 20" bzw. 20'" mit einem Auflageelement 6" bzw. 6'" aufweisen, wobei das Auflageelement 6" bzw. 6'" des dritten passiven elektrischen Bauelements 20" bzw. 20' in gleicher Form wie das Auflageelement 6 des ersten passiven elektrischen Bauelements 20 in der Ausnahme 3 des Kühlkörpers 2 angeordnet und mit dem Kühlkörper 2 verbunden ist, so dass die bezüglich dem ersten passiven elektrischen Bauelement 20 oben aufgeführte Beschreibung auch für das dritte passive elektrische Bauelement 20" bzw. 20'" zutrifft. Beim Ausführungsbeispiel liegt das dritte passive elektrische Bauelement 20" bzw. 20'" in Form eines elektrischen Widerstands 20" und das Auflageelement des dritten passiven elektrischen Bauelements 20" in Form des Gehäuses 6" des elektrischen Widerstands vor oder das dritte passive elektrische Bauelement liegt in Form eines Kondensators 20"' vor und das Auflageelement des dritten passiven elektrischen Bauelements 20"' liegt in Form des Gehäuses 6'" des Kondensators vor.

Der Kühlkörper kann z.B. als Luftkühlkörper oder wie beim Ausführungsbeispiel als Flüssigkeitskühlkörper ausgebildet sein. Der Kühlkörper 2 weist beim Ausführungsbeispiel durch den Kühlkörper 2 verlaufende Kanäle 18 auf durch die im Betrieb der Leistungsbauelementeinrichtung 1 eine Kühlflüssigkeit, die vorzugsweise in Form von Wasser oder einem Öl vorliegt, fließt und Wärme von Kühlkörper aufnimmt und nach Außen abführt. Wenn der Kühlkörper als Luftkühlkörper ausgebildet ist, weist der Kühlkörper im Allgemeinen Kühlfinnen auf an denen im Betrieb Luft zur Kühlung vorbeiströmt und Wärme von Kühlkörper aufnimmt und nach Außen abführt.

Es sei an dieser Stelle angemerkt, dass im Sinne der Erfindung unter einem Kühlkörper ein fester Körper verstanden wird, der im Betrieb der Leistungsbauelementeinrichtung dazu dient von einem anderen festen Körper Wärme aufzunehmen und die aufgenommene Wärme oder einen überwiegenden Teil der aufgenommenen Wärme an ein flüssiges Medium und/oder an ein gasförmiges Medium, das einen Kontakt mit dem Kühlkörper aufweist, abzugeben. Gegebenenfalls kann ein kleiner Teil der vom Kühlkörper aufgenommenen Wärme an einen weiteren festen Körper abgegeben werden.

## Patentansprüche

1. Leistungsbauelementeinrichtung mit einem Kühlkörper (2), der eine Ausnahme (3) aufweist, wobei die Ausnahme (3) eine Bodenfläche (4) und eine erste Seitenfläche (5) aufweist, wobei die erste Seitenfläche (5) der Ausnahme (3) einen Wickel (α) zur Bodenfläche (4) von kleiner als 90° aufweist,wobei die Leistungsbauelementeinrichtung (1,1',1") ein erstes passives elektrisches Bauelement (20) mit einem Auflageelement (6) aufweist, wobei das Auflageelement (6) auf der Bodenfläche (4) angeordnet ist und die der ersten Seitenfläche (5) der Ausnahme (3) zugewandte erste Seitenfläche (7) des Auflageelements (6) den gleichen Wickel zur Bodenfläche (4) aufweist wie die erste Seitenfläche (5) der Ausnahme (3) zur Bodenfläche (4), wobei die Leistungsbauelementeinrichtung (1,1',1") ein auf der Bodenfläche (4) angeordnetes Druckübertragungselement (19) aufweist, wobei das Druckübertragungselement (19) eine der ersten Seitenfläche (7) des Auflageelements (19) abgewandte erste Druckübertragungselementseitenfläche (14) aufweist, wobei die Bodenfläche (4) einen Wickel (y) zur ersten Druckübertragungselementseitenfläche (14) von kleiner als 90° aufweist, wobei die Leistungsbauelementeinrichtung (1,1',1") eine Druckerzeugungsvorrichtung (10) aufweist, die eine Kraft (F) auf die erste Druckübertragungselementseitenfläche (14) ausübt, so dass über das Druckübertragungselement (19) das Auflageelement (6) gegen die erste Seitenfläche (5) der Ausnahme (3) gedrückt wird.

2. Leistungsbauelementeinrichtung nach Anspruch 1, **dadurch gekennzeichnet, dass** das Druckübertragungselement (19) gegenüberliegend zu einer der ersten Seitenfläche (7) des Auflageelements (6) abgewandten zweiten Seitenfläche (8) des Auflageelements (6) angeordnet ist.

3. Leistungsbauelementeinrichtung nach Anspruch 2, **dadurch gekennzeichnet, dass** die Bodenfläche (4) einen Wickel (δ) zur zweiten Seitenfläche (8) des Auflageelements (6) von kleiner als 90 aufweist und die Bodenfläche (4) zu einer der zweiten Seitenfläche (8) des Auflageelements (6) zugewandten zweiten Druckübertragungselementseitenfläche (9) des Druckübertragungselements (19) den gleichen Winkel aufweist wie die Bodenfläche (4) zur zweiten Seitenfläche (8) des Auflageelements (6).

4. Leistungsbauelementeinrichtung nach Anspruch 1, **dadurch gekennzeichnet, dass** das Druckübertragungselement (19) einstückig mit dem Auflageelement (6) ausgebildet ist.

5. Leistungsbauelementeinrichtung nach einem der vorhergehenden Ansprüche, **dadurch gekennzeichnet, dass** die Ausnahme (3) eine der ersten Seitenfläche (5) der Ausnahme (3) zugewandte zweite Seitenfläche (16), welche die Seitenfläche einer ersten Seitenwand (15) des Kühlkörpers (2) bildet, aufweist, wobei die erste Seitenwand (15) des Kühlkörpers (2) die Gegenkraft zur Kraft (F), die die Druckerzeugungsvorrichtung (10) auf die erste Druckübertragungselementseitenfläche (14) ausübt, aufnimmt.

6. Leistungsbauelementeinrichtung nach einem der vorhergehenden Ansprüche, **dadurch gekennzeichnet, dass** das erste passive elektrische Bauelement (20) als Transformator mit einem magnetisch leitfähigen Kern oder als Drossel mit einem magnetisch leitfähigen Kern ausgebildet ist und das Auflageelement (6) in Form des magnetisch leitfähigen Kerns des Transformators oder der Drossel ausgebildet ist, oder das erste passive elektrische Bauelement als elektrischer Widerstand und das Auflageelement in Form des Gehäuses des elektrischen Widerstands ausgebildet ist, oder das erste passive elektrische Bauelement als Kondensator ausgebildet ist und das Auflageelement in Form des Gehäuses des Kondensators ausgebildet ist.

7. Leistungsbauelementeinrichtung nach einem der vorhergehenden Ansprüche, **dadurch gekennzeichnet, dass** zwischen dem Auflageelement (6) und der Bodenfläche(4) eine erste wärmeleitende Schicht (22) angeordnet ist und zwischen dem Auflageelement (6) und erster Seitenfläche (5) der Ausnahme (3) eine zweite wärmeleitende Schicht (23) angeordnet ist.

8. Leistungsbauelementeinrichtung nach Anspruch 7, **dadurch gekennzeichnet, dass** die Dicken der ersten und zweiten Schicht (22,23) unterschiedlich sind und/oder das Material aus dem die erste und die zweite wärmeleitende Schicht (22,23) bestehen unterschiedlich ist.

9. Leistungsbauelementeinrichtung nach einem der vorhergehenden Ansprüche, **dadurch gekennzeichnet, dass** die Leistungsbauelementeinrichtung (1,1',1") ein zweites passives elektrisches Bauelement (20') mit einem Auflageelement (6') aufweist, wobei das Auflageelement (6') des zweiten passiven elektrischen Bauelements (20') in gleicher Form wie das Auflageelement (6) des ersten passiven elektrisches Bauelements (20) in der Ausnahme (3) des Kühlkörpers (2) angeordnet und mit dem Kühlkörper (2) verbunden ist.

10. Leistungsbauelementeinrichtung nach Anspruch 9, **dadurch gekennzeichnet, dass** das zweite passive elektrische Bauelement (20') als Transformator mit einem magnetisch leitfähigen Kern oder als Drossel mit einem magnetisch leitfähigen Kern ausgebildet ist und das Auflageelement (6') des zweiten passiven elektrischen Bauelements in Form des magnetisch leitfähigen Kerns des Transformators oder der Drossel ausgebildet ist, oder das zweite passive elektrische Bauelement als elektrischer Widerstand und das Auflageelement des zweiten passiven elektrischen Bauelements in Form des Gehäuses des elektrischen Widerstands ausgebildet ist, oder das zweite passive elektrische Bauelement als Kondensator ausgebildet ist und das Auflageelement des zweiten passiven elektrischen Bauelements in Form des Gehäuses des Kondensators ausgebildet ist.
